(19) Europäisches Patentamt
European Patent Office
Office européen des brevets

(11) EP 4 007 136 A1

(12) EUROPEAN PATENT APPLICATION
published in accordance with Art. 153(4) EPC

(43) Date of publication:
01.06.2022 Bulletin 2022/22

(51) International Patent Classification (IPC):
H02K 33/18 (2006.01)    H02N 15/00 (2006.01)
H01L 21/68 (2006.01)

(21) Application number: 20843517.2

(22) Date of filing: 16.03.2020

(52) Cooperative Patent Classification (CPC):
H01L 21/68; H02K 33/18; H02N 15/00

(86) International application number:
PCT/JP2020/011412

(87) International publication number:
WO 2021/014679 (28.01.2021 Gazette 2021/04)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 24.07.2019 JP 2019136016

(71) Applicant: Hitachi, Ltd.
Tokyo 100-8280 (JP)

(72) Inventors:
• TAKAHASHI, Motohiro
Tokyo 100-8280 (JP)
• OGAWA, Hironori
Tokyo 100-8280 (JP)
• KATO, Takanori
Tokyo 100-8280 (JP)
• TAKAHASHI, Hiroki
Tokyo 100-8280 (JP)
• ETOH, Jun
Tokyo 100-8280 (JP)

(74) Representative: Mewburn Ellis LLP
Aurora Building
Counterslip
Bristol BS1 6BX (GB)

(54) **MAGNETIC LEVITATION STAGE DEVICE, AND CHARGED PARTICLE BEAM DEVICE OR VACUUM DEVICE IN WHICH MAGNETIC LEVITATION STAGE DEVICE IS USED**

(57) Provided are a stage device, a charged particle beam device, and a vacuum device with which it is possible to increase the speed and acceleration of positioning and to suppress leakage of a magnetic field. To achieve this purpose, this magnetic levitation stage device is equipped with a levitating part, a non-levitating part, a horizontal thrust motor that imparts horizontal thrust to the levitating part when a coil current flows in a horizontal thrust coil, and a vertical thrust motor that imparts vertical thrust to the levitating part when the coil current flows in a vertical thrust coil, wherein: on the lower section of the levitating part, a vertical thrust assist yoke 6ZA is provided at a position facing the end section of the horizontal thrust coil protruding from a horizontal thrust yoke; and when the coil current flows in the horizontal thrust coil, simultaneously with the generation of horizontal thrust by the horizontal thrust yoke, vertical-direction assist thrust $F_{ZA}$ is also generated by the vertical thrust assist yoke.

FIG. 9

**Description**

Technical Field

The present disclosure relates to a magnetic levitation stage device and a charged particle beam device or vacuum device using the same.

Background Art

As a multiple point support assembly that precisely positions and supports a table on which a device such as a semiconductor wafer is placed, the device stage assembly described in Patent Literature 1 is known.

As described in Claim 1 of the literature, the device stage assembly in Patent Literature 1 includes a device stage that retains the device, a mover housing, a support assembly, and a control system. The support assembly includes at least four spaced apart Z device stage movers connected to the device stage and moves the device stage relative to the mover housing. The control system controls the Z device stage movers to inhibit deformation of the device stage during movement of the device stage by the Z device stage movers.

The Z device stage movers in Patent Literature 1 are intended to magnetically levitate the device stage by giving it a force in the Z axis (vertical) direction. They include a magnet and conductor, in which an electric current passing through the conductor causes the conductor to interact with the magnetic field of the magnet and generates a force (Lorentz force) between the magnet and conductor. The Z device stage movers move and support the device stage along the Z axis around the X axis and around the Y axis selectively (see Paragraphs 0058 to 0061 and so on of the literature).

In addition, the device stage assembly includes a stage mover assembly (see Paragraphs 0028 and so on of the literature). The stage mover assembly is comprised of a mover housing, a guide assembly, a fluid bearing, a magnetic bearing or roller bearing and so on and moves the mover housing in the X axis direction and Y axis direction (see Paragraph 0035 to 0040 and so on of the literature). The control system controls the stage mover assembly and the support assembly to precisely position the device stage and device (see Paragraph 0078 and so on of the literature).

Patent Literature 2 discloses a stage that performs X and Z driving by switching the coils for use in an X motor and a Z motor on an amplifier side. In Patent Literature 2, an X yoke and a Z yoke are arranged on the table and a thrust force is given to the stage by applying an electric current to a coil array spread all over the base planarly.

Citation List

Patent Literature

[0007]

　　Patent Literature 1: U.S. Unexamined Patent Application Publication No. 2002/0137358
　　Patent Literature 2: Japanese Patent Application Laid-Open No. H11(1999)-069762

Summary of Invention

Technical Problem

In the processes of manufacture, measurement and inspection of semiconductor wafers, a stage device such as the above device stage assembly is used in order to position a semiconductor wafer precisely. In such a stage device, higher speed and higher acceleration in positioning are demanded to shorten the semiconductor wafer positioning time.

However, in the conventional device stage assembly, for example, if the speed and acceleration in positioning the device stage is increased in order to shorten the semiconductor wafer positioning time, the pitching moment due to a height difference between the inertia force and thrust force of the device stage would increase and the size of the Z device stage movers must be increased in order to counteract this. With this size increase, magnetic field leakage from the Z device stage movers would increase.

Magnetic field leakage in the stage device might cause distortion of an electron beam, for example, in a charged particle beam device such as an electronic microscope, posing a problem that the electron beam irradiation accuracy declines. On the other hand, if the motor of the device stage is shifted to a lower position from the sample surface in order to reduce the influence of the magnetic field, when the height difference between the inertia force and thrust force increases, similarly the pitching moment would increase, which would require a larger device stage assembly, resulting in a decline in responsiveness.

Therefore, the present invention has an object to provide a magnetic levitation stage device that can achieve higher speed and higher acceleration in positioning without an increase in the size of the Z motor and can suppress magnetic field leakage, and a charged particle beam device or vacuum device using the same.

Solution to Problem

In order to solve the above problem, a magnetic levitation stage device according to the present invention comprises: a levitated part having a sample stage on which a sample is placed; a non-levitated part located under the levitated part; a horizontal thrust motor that has a horizontal thrust yoke located on a lower portion of the levitated part and a horizonal thrust coil located on an upper portion of the non-levitated part and gives a horizontal thrust force to the levitated part when coil current is applied to the horizontal thrust coil; and a vertical thrust motor that has a vertical thrust yoke located on the lower portion of the levitated part and a vertical thrust coil located on the upper portion of the non-levitated part and gives a vertical thrust force to the levitated part when coil current is applied to the vertical thrust coil. On the lower portion of the levitated part, a vertical thrust assist yoke is located in a position to face an end of the horizontal thrust coil protruding from the horizontal thrust yoke, and when coil current is applied to the horizontal thrust coil, the horizontal thrust yoke generates the horizontal thrust force and at the same time the vertical thrust assist yoke also generates a vertical assist thrust force.

Advantageous Effects of Invention

According to the magnetic levitation stage device in the present invention, higher speed and higher acceleration in positioning can be achieved without an increase in Z motor size and also magnetic field leakage can be suppressed. Therefore, when it is incorporated in a charged particle beam device, a harmful effect on electron beam irradiation accuracy can be suppressed.

Brief Description of Drawings

Fig. 1 is a conceptual diagram that shows the general structure of a conventional magnetic levitation stage device.
Fig. 2 is a conceptual diagram that shows the reaction force and the action of a moment in the conventional magnetic levitation stage device.
Fig. 3 is a conceptual diagram that shows the general structure of the magnetic levitation stage device according to the first embodiment.
Fig. 4 is a conceptual diagram that shows the reaction force and the action of a moment in the magnetic levitation stage device according to the first embodiment.
Fig. 5 is a perspective view that explains the general structure of the magnetic levitation stage device according to the first embodiment.
Fig. 6 is a perspective view of the magnetic levitation stage device according to the first embodiment, in which the top table is not shown.
Fig. 7 is a perspective view that explains the structure of the non-levitated part according to the first embodiment.
Fig. 8 is a perspective view that explains the structure of the levitated part according to the first embodiment.
Fig. 9 is a perspective view that explains a Z assist thrust force according to the first embodiment.
Fig. 10 is a view of the structure of an X motor according to the first embodiment.
Fig. 11A is a side view of the X motor according to the first embodiment.
Fig. 11B is a plan view of the X motor according to the first embodiment.
Fig. 12 is a sectional view of the X motor, taken along the XZ plane of the X motor according to the first embodiment.
Fig. 13 is a sectional view of the X motor, taken along the YZ plane of the X motor according to the first embodiment.
Fig. 14 is an example of motor arrangement in which the Z thrust assist function is not established.
Fig. 15 is an example of motor arrangement in which it is impossible to compensate for the moment around the Z axis.
Fig. 16 is an example of motor arrangement in which the Z thrust assist function is established.
Fig. 17 is a view that explains the design method for the Z thrust assist motor.
Fig. 18A is a perspective view that explains the structure of the levitated part according to the second embodiment.
Fig. 18B is a view of the structure of the X motor according to the second embodiment.
Fig. 18C is a sectional view of the X motor according to the second embodiment.
Fig. 19 is a conceptual diagram of the charged particle beam device according to the third embodiment.

Description of Embodiments

Hereinafter, a magnetic levitation stage device and a charged particle beam device and vacuum device using the same will be described referring to drawings.

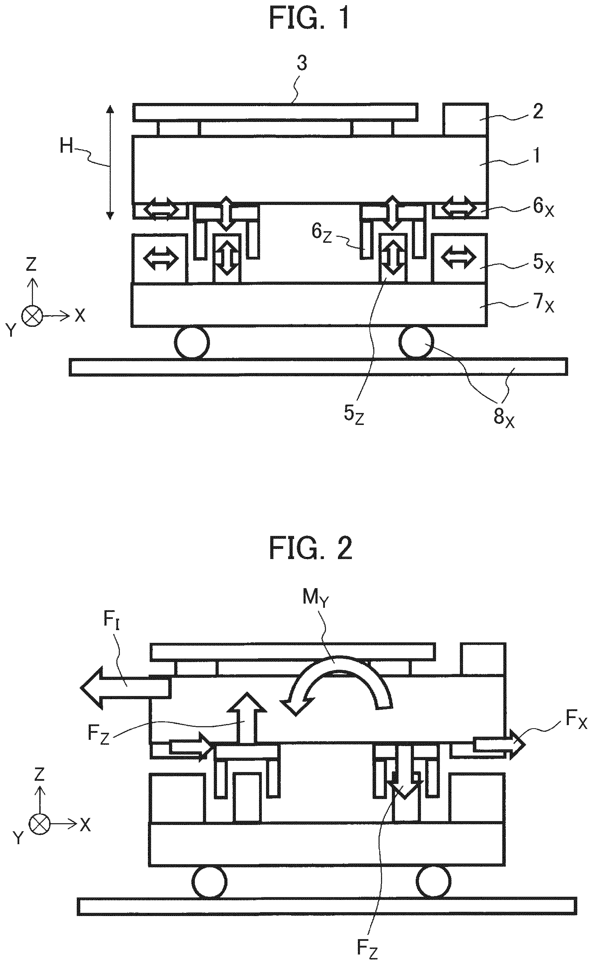

First, the problem that arises in the conventional magnetic levitation stage device will be explained using Fig. 1 and Fig. 2.

Fig. 1 is a conceptual diagram that shows the general structure of a conventional magnetic levitation stage device. In the magnetic levitation stage device shown here, a top table 1 (levitated part), on which a sample such as a semiconductor wafer is placed, is magnetically levitated with respect to an X table 7x (non-levitated part) and the sample such as a semiconductor wafer is moved horizontally by two types of motions, namely coarse motion using the guides which will be stated later and a fine motion using the motors which will be stated later. In addition, the levitated part is positioned and moved relative to the non-levitated part with six degrees of freedom, by using the motors which will be stated later.

As shown in Fig. 1, a bar mirror 2 and a sample stage 3 are fixed on the upper surface of a top table 1 as the main portion of the levitated part. A sample such as a semiconductor wafer 3a is placed on the sample stage 3 and the bar mirror 2 is measured with a laser interferometer 140 which will be stated later or the like to grasp the position of the sample. In addition, an X coil $5_X$ and a Z coil 5z are installed on the upper surface of an X table $7_X$ as the main portion of the non-levitated part and an X yoke $6_x$ and a Z yoke $6_Z$ are fixed on the lower surface of the top table 1. The X coil $5_X$ and X yoke $6_X$ constitute a voice coil motor 4 (hereinafter, X motor 4x) that generates an X thrust force $F_X$ in the X direction and the Z coil 5z and Z yoke 6z constitute a voice coil motor 4 (hereinafter Z motor 4z) that generates a Z thrust force $F_Z$ in the Z direction. Although not shown in Fig. 1, a Y coil $5_Y$ on the upper surface of the X table $7_X$ and a Y yoke $6_Y$ on the lower surface of the top table 1 constitute a voice coil motor 4 (hereinafter, Y motor $4_Y$) that generates a Y thrust force Fy in the Y direction. Hereinafter, it is assumed that the X motor $4_X$ and Y motor $4_Y$ are the same in structure and different only in the direction of installation. In the above structure, the X motor $4_X$ and Y motor $4_Y$ function as horizontal thrust motors and the Z motor $4_Z$ functions as a vertical thrust motor.

The X table $7_X$ of the non-levitated part is guided by an X guide $8_X$, for example, comprised of a wheel and a rail and can move for a distance of hundreds of millimeters in the X direction. The top table 1 of the levitated part moves in a range of several millimeters with respect to the X table 7x of the non-levitated part. In other words, the magnetic levitation mechanism of the magnetic levitation stage device shown in Fig. 1 has the function as a fine motion mechanism.

Fig. 2 is a view which shows the reaction force and moment in the case that a thrust force to move the top table 1 at high speed is exerted. As shown here, when the X thrust force Fx is generated in the +X direction by the X motor 4x in order to move the top table 1 at high speed, an inertial force $F_I$ due to the mass of the top table 1 and the mirror and yoke fixed on it is generated in the -X direction. Generally, since the sample stage 3 and bar mirror 2 mounted on the top table 1 are large in size and made of ceramics and large in weight, the center of gravity of the levitated part including the top table 1 tends to be in a high position. Furthermore, in a magnetic levitation stage device expected to be also used in a charged particle beam device, the X motor $4_X$ and Z motor $4_Z$, which may cause magnetic field leakage, are located under the top table 1. As a consequence, the distance between the X thrust force $F_X$ and inertial force $F_I$ tends to be larger and the rotation moment My around the Y axis that is generated by the couple of these forces tends to be large. Therefore, in order to compensate for the moment My, in the conventional magnetic levitation stage device, the Z motor 4z requires a large Z thrust force Fz. For this reason, in the past it has been inevitable that the Z motor 4z generates a large thrust force and has a large size, which poses a problem that the decline in responsiveness due to the increased movable mass and the decline in the resonance frequency of the levitated part become an impediment and it is difficult to achieve higher speed.

First Embodiment

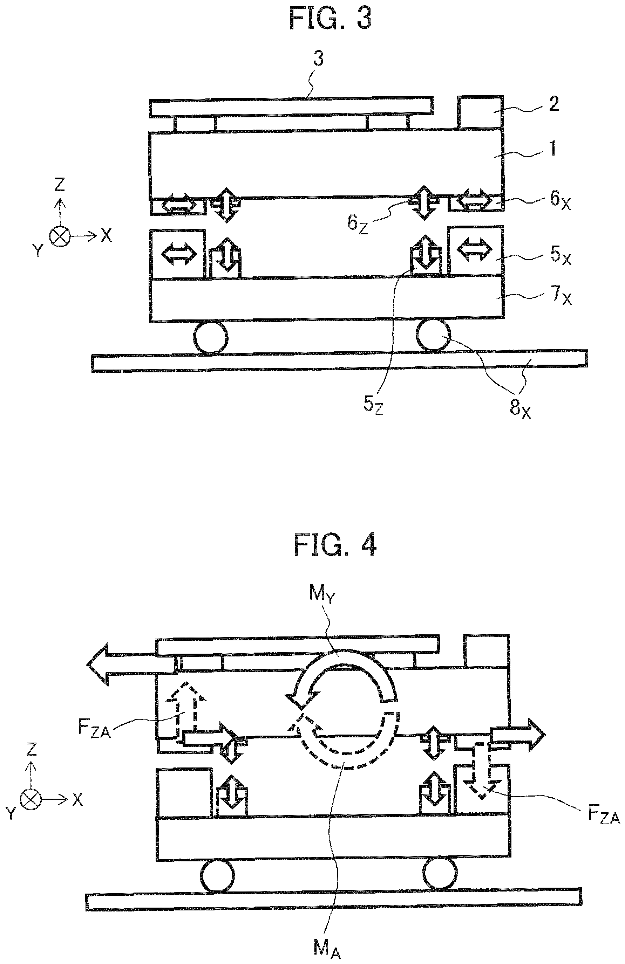

Next, a magnetic levitation stage device 100 according to the first embodiment of the present invention that improves the above problem will be described using Fig. 3 to Fig. 17. Repeated description of the same points as in Fig. 1 and Fig. 2 is omitted.

Fig. 3 is a conceptual diagram that shows the general structure of the magnetic levitation stage device 100 according to this embodiment and Fig. 4 is a conceptual diagram that shows the thrust force and the action of moment during acceleration of the top table 1 in the same way as Fig. 2. As shown in both the figures, the magnetic levitation stage device 100 adds the function to generate a Z assist thrust force $F_{ZA}$ in the Z axis direction to the X motor $4_X$ so that the Z yoke $6_Z$ of the Z motor $4_Z$ is smaller in size and the levitated part is lighter in weight and the natural frequency of the levitated part is improved. And the Z assist thrust force $F_{ZA}$ generated by the X motor $4_X$ generates an opposing moment $M_A$ that counteracts the rotation moment My during acceleration.

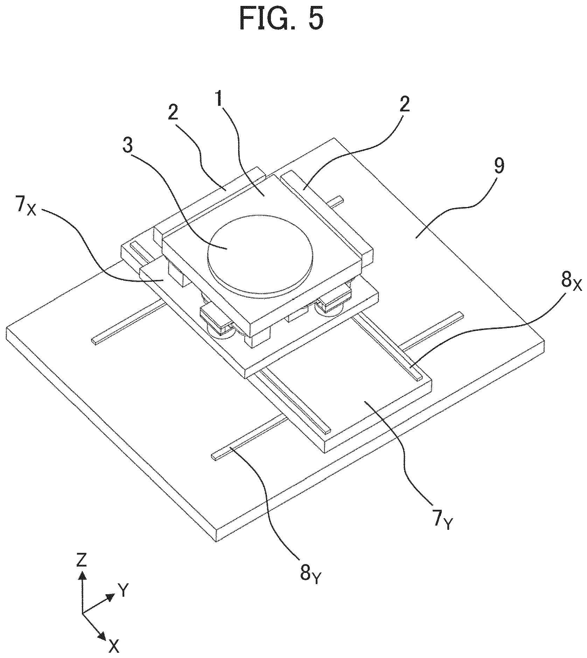

Fig. 5 is a perspective view of the general structure of the magnetic levitation stage device 100 according to this embodiment. As shown here, in the magnetic levitation stage device 100, a Y table $7_Y$ is mounted on a base 9 and the Y table $7_Y$ is guided by a Y guide $8_Y$ in the Y direction. Also, an X table $7_X$ is mounted on the Y table $7_Y$ and the X table $7_X$ is guided by an X guide $8_X$ in the X direction. Furthermore, the levitated part including the top table 1 is positioned on the X table $7_X$ as a fine motion mechanism.

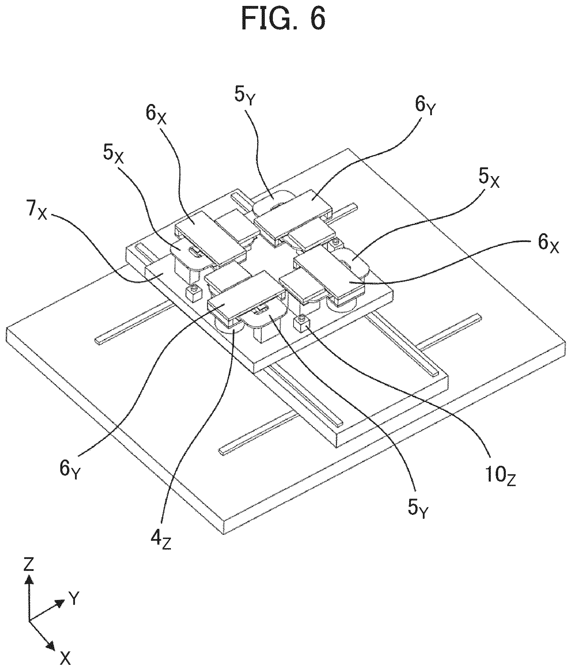

Fig. 6 is a perspective view that illustrates the structure of each motor while the top table 1, bar mirror 2, and sample stage 3 are not shown. As shown here, in this embodiment, a pair of X coils $5_X$ and a pair of Y coils $5_Y$ are arranged in a staggered pattern on the X table $7_X$ and these give an X thrust force Fx or Y thrust force Fy to a pair of X yokes $6_X$ and a pair of Y yokes $6_Y$ on the levitated part side. In addition, three Z sensors $10_Z$ that measure the displacement of the levitated part in the Z direction are installed on the X table $7_X$.

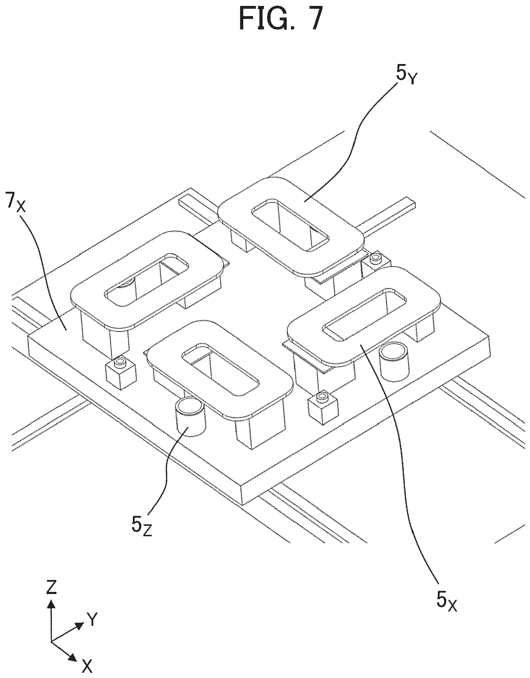

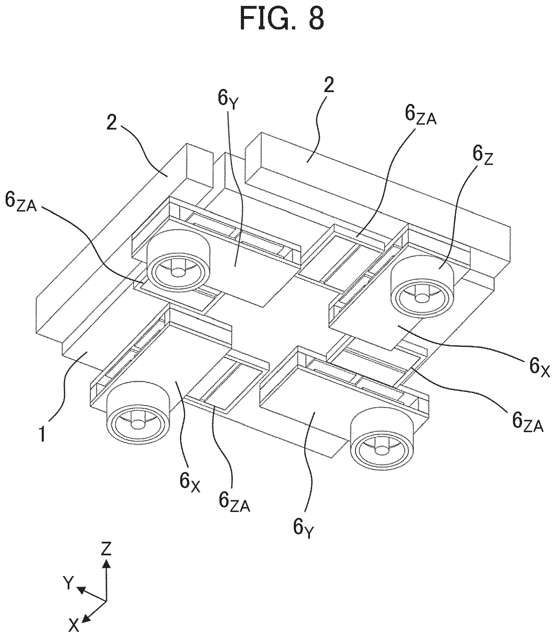

Next, the structures of the non-levitated part and levitated part of the magnetic levitation stage device will be further detailed using the perspective views of Fig. 7 and Fig. 8. As in the conventional magnetic levitation stage device, in the magnetic levitation stage device 100 in this embodiment, the levitated part in Fig. 8 is positioned relative to the non-levitated part in Fig. 7 with six degrees of freedom and moved relatively.

As shown in Fig. 7, the X coils 5x and Y coils $5_Y$ provided on the X table $7_X$ are rectangular roughly in the shape of rectangle and the Z coils 5z provided on the X table 7x are roughly cylindrical. These coils are produced by winding round or square core electric wires tens to hundreds of turns and then molding with resin to bind them. In order to make the X yokes 6x and Y yokes $6_Y$ in Fig. 8 lightweight and have a low magnetic field, the thickness of the X coils $5_X$ and Y coils $5_Y$ in Fig. 7 is decreased to maintain the magnetic flux density of each yoke. In addition, by applying electric current $I_Z$ to the Z coil $5_Z$ in Fig. 7, Z thrust force $F_Z$ is given to the Z yoke $6_Z$ of the Z motor $4_Z$ in Fig. 8.

Furthermore, as shown in Fig. 8, four assist yokes (hereinafter Z assist yokes $6_{ZA}$) to constitute a motor for generating a thrust force in the Z direction (hereinafter Z assist motor $4_{ZA}$) using the coil currents $I_X$ and $I_Y$ flowing in the X motor $4_X$ and Y motor $4_Y$ are installed on the lower surface of the top table 1.

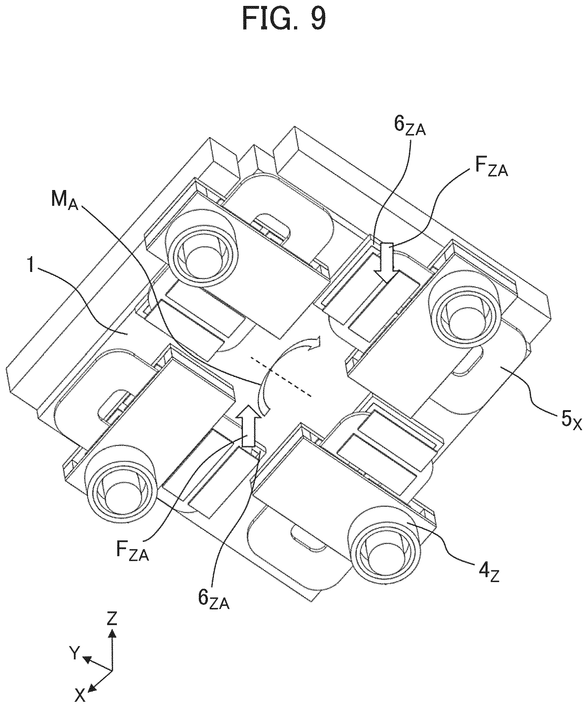

Fig. 9 is a view that explains the function of the Z assist motor $4_{ZA}$ constituted by an X motor $4_X$ in this embodiment. This figure illustrates a state in which an opposing moment $M_A$ to counteract the rotation moment $M_Y$ generated during acceleration is generated by making a pair of symmetrically arranged Z assist yokes $6_{ZA}$ generate upward and downward Z assist thrust forces $F_{ZA}$.

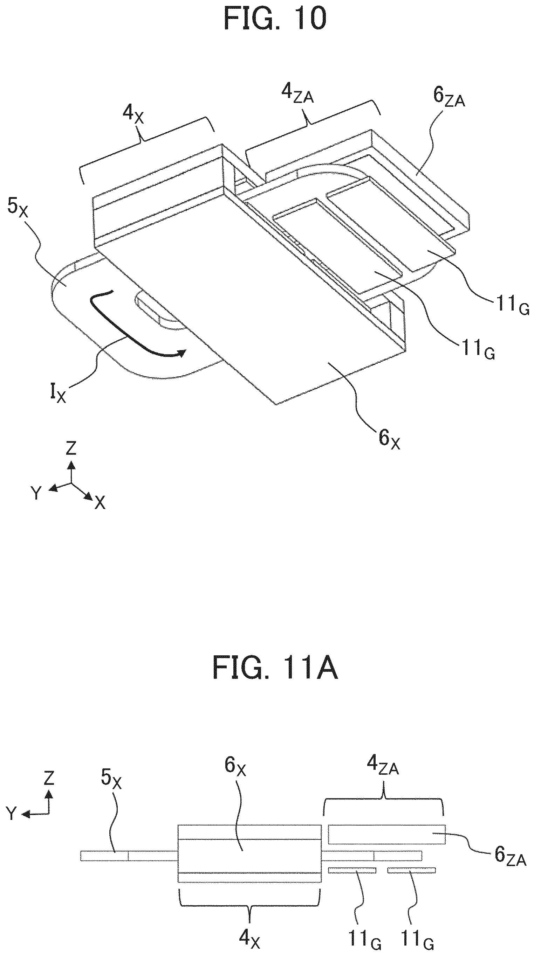

Fig. 10 is an enlarged perspective view of one X motor 4x in Fig. 9 and its vicinity. As shown here, the X coil 5x protrudes from the X yoke $6_X$ on the both sides and coil current $I_X$ flows in the X coil $5_X$ in the direction indicated in the figure. Above the protruding portion of the X coil 5x, a Z assist yoke $6_{ZA}$ is fixed on the lower surface of the top table 1 and under the protruding portion of the X coil 5x, a permanent magnet $11_G$ for gravity compensation is fixed on the upper surface of the X table 7x. Due to the structure shown here, the X yoke $6_X$ and the X coil $5_X$ facing it form an X motor 4x that generates an X thrust force Fx and the Z assist yoke $6_{ZA}$ and the X coil $5_X$ facing it form a Z assist motor $4_{ZA}$ that generates a Z assist thrust force $F_{ZA}$.

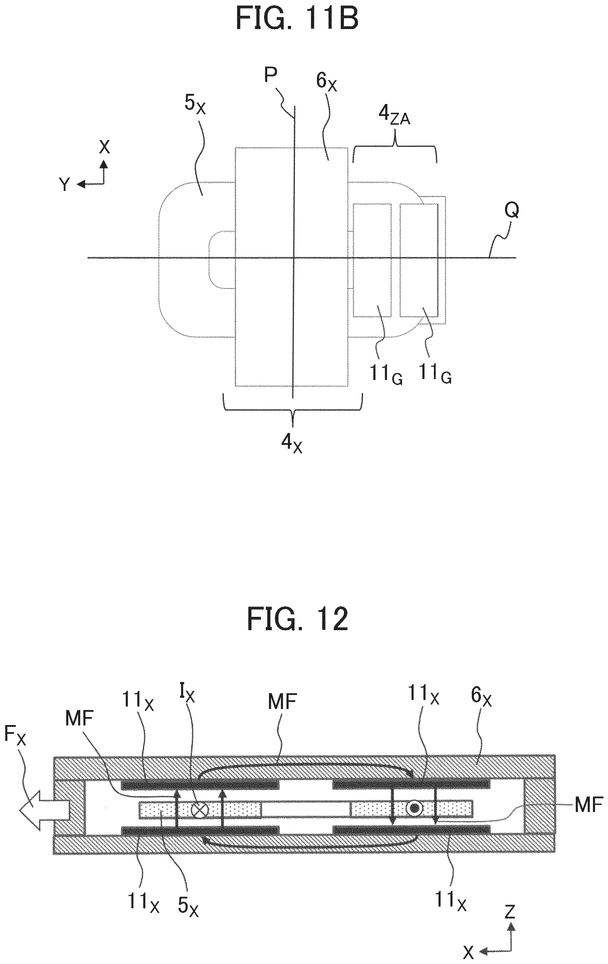

Fig. 11A is a side view of the X motor 4x and Z assist motor $4_{ZA}$ in Fig. 10 that are projected on the ZY plane. Fig. 11B is a side view of the X motor 4x and Z assist motor $4_{ZA}$ in Fig. 10 that are projected on the XY plane.

Next, the principle of operation of the X motor 4x in this embodiment will be explained using Fig. 12. Fig. 12 is a sectional view of the X motor $4_X$, taken along the plane P in Fig. 11B. As shown here, the X motor 4x forms a magnetic circuit indicated by the counterclockwise magnetic flux MF in the figure through the permanent magnet $11_X$ fixed inside the X yoke 6x. Then, as coil current $I_X$ flows in the X coil 5x, the X motor 4x generates an X thrust force $F_X$.

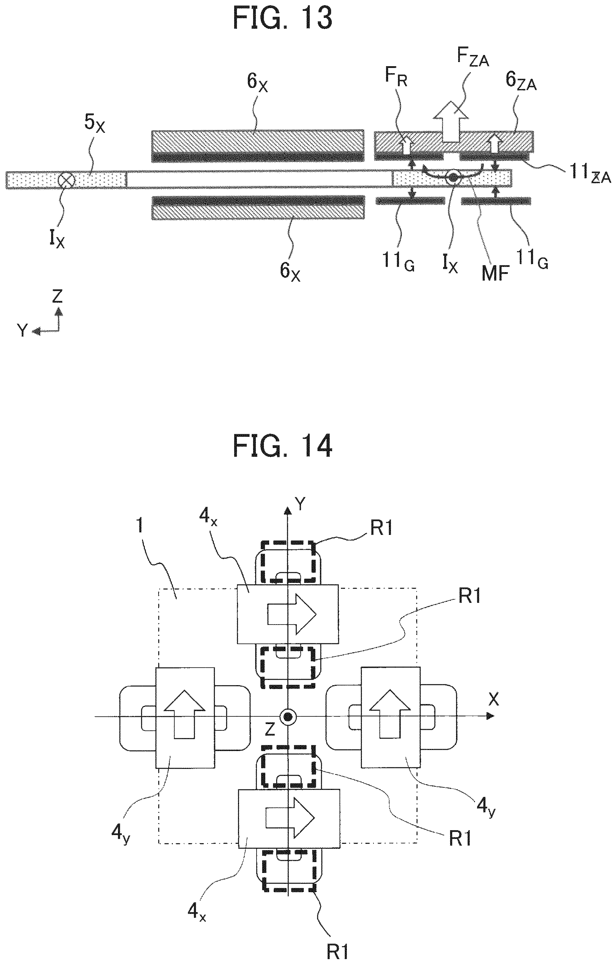

Next, the principle of operation of the Z assist motor $4_{ZA}$ will be explained using Fig. 13. Fig. 13 is a sectional view of the Z assist motor $4_{ZA}$, taken along the plane Q in Fig. 11B. As shown here, a pair of permanent magnets $11_{ZA}$ installed on the lower surface of the Z assist yoke $6_{ZA}$ generate a magnetic flux MF that goes across in the X coil $5_X$ from the inner circumference side to the outer circumference side in the Y direction. Then, as the coil current $I_X$ flows in the X coil $5_X$, the Z assist motor $4_{ZA}$ generates a Z assist thrust force $F_{ZA}$. In addition, since a repulsion force $F_R$ is generated between the permanent magnet $11_G$ on the non-levitated part side and the permanent magnet $11_{ZA}$ of the Z assist yoke $6_{ZA}$ on the levitated part side, this is used for gravity compensation of the levitated part. This eliminates the need for coil current for gravity compensation of the levitated part and can avoid excessive coil heat generation. In addition, the permanent magnet $11_G$ on the non-levitated part has an effect to strengthen the magnetic flux MF shown in Fig. 13 and also has an effect to improve the thrust force constant of the Z assist motor $4_{ZA}$ as well as the effect for gravity compensation. Furthermore, since the coil current in the X motor $4_X$ is used to activate the Z assist motor $4_{ZA}$, it is unnecessary to add a new current amplifier for the Z assist motor $4_{ZA}$, so the stage speed can be increased without impairing the compactness and low cost of the device.

The structure of the Z assist motor $4_{ZA}$ is not limited to the shape shown in Fig. 13. Another structure is acceptable provided that the yoke shape enables generation of a magnetic flux that goes across the coil from inside the coil to outside or in the opposite direction.

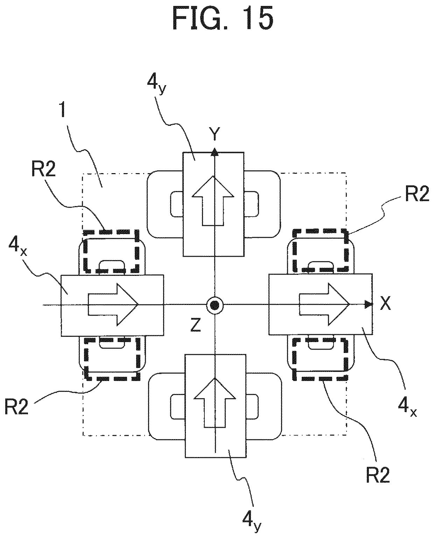

Next, the arrangement of motors that enables establishment of the function of the Z assist motor $4_{ZA}$ will be explained using Fig. 14 to Fig. 16. In these figures, two axes that intersect orthogonally almost at the center of the projection plane of the top table 1 as the levitated part are defined as an X axis and a Y axis and the position of the Z assist motor $4_{ZA}$ is indicated by dotted lines. Fig. 14 and Fig. 15 show an inadequate arrangement of the Z assist motors

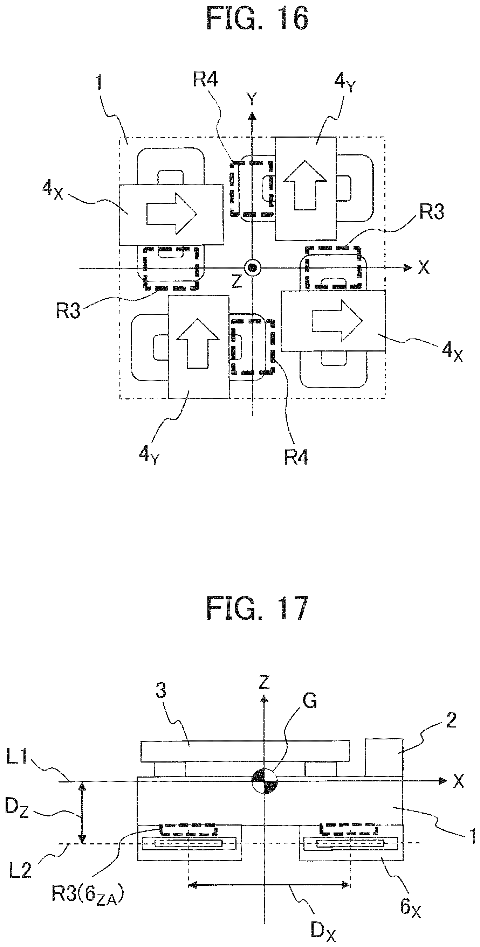

$4_{ZA}$ and Fig. 16 shows an adequate arrangement of the Z assist motors $4_{ZA}$.

If a pair of X motors $4_X$ are arranged in a way that the long side direction of the X coils $5_X$ overlaps the Y axis as shown in Fig. 14, the Z assist motor $4_{ZA}$ is activated in the position of range R1 during X movement and thus the Z assist thrust forces $F_{ZA}$ would lie side by side on the Y axis. In this case, an opposing moment $M_A$ around the Y axis cannot be generated, so the arrangement of X motors 4x as shown in Fig. 14 is inadequate. For the same reason, the arrangement of Y motors $4_Y$ in Fig. 14, in which the long side direction of the Y coils $5_Y$ overlaps the X axis, is also inadequate.

On the other hand, if a pair of X motors 4x are arranged in a way that the short side direction of the X coil 5x overlaps the X axis as shown in Fig. 15, the Z assist motor $4_{ZA}$ is activated in the position of range R2 during X movement and an opposing moment $M_A$ to compensate for the rotation moment My around the Y axis can be generated. However, the X motors 4x that generate X thrust force $F_X$ lie side by side on the X axis and are not spaced apart in the Y direction, so it is impossible to generate a moment around the Z axis and impossible to achieve magnetic levitation. Earnshaw's theorem demonstrates that stable magnetic levitation is difficult if thrust force control in the directions of six degrees of freedom cannot be performed. In other words, the arrangement shown in Fig. 15 is inadequate. For the same reason, the arrangement of Y motors $4_Y$ in Fig. 15, in which the short side direction of the Y coils $5_Y$ overlaps the Y axis, is also inadequate.

In contrast, if as shown in Fig. 16, a pair of X motors 4x are spaced from each other in both the X direction and Y direction and arranged in a staggered pattern and also a pair of Y motors $4_Y$ are spaced from each other in both the X direction and Y direction and arranged in a staggered pattern, in other words, only when the Y yoke $6_Y$ of one Y motor $4_Y$ is arranged in the first quadrant of the XY plane, the X yoke 6x of one X motor 4x is arranged in the second quadrant, the Y yoke $6_Y$ of the other Y motor $4_Y$ is arranged in the third quadrant, and the X yoke 6x of the other X motor 4x is arranged in the fourth quadrant, it is possible to establish both the function to generate a moment around the Z axis and the function of the Z assist motor $4_{ZA}$. In other words, it is desirable that the X yokes $6_X$ should be spaced from each other in the Y axis direction and the Y yokes $6_Y$ should be spaced from each other in the X axis direction. In addition, when the position of the Z assist motor $4_{ZA}$ integral with the X motor $4_X$ coincides with the range R3 on the X axis, only a moment around the Y axis can be generated without generating an excessive moment around the X axis during acceleration in the X direction, so excessive vibration does not occur. Similarly, when the position of the Z assist motor $4_{ZA}$ integral with the Y motor $4_Z$ coincides with the range R4 on the Y axis, only a moment around the X axis can be generated without generating an excessive moment around the Y axis during acceleration in the Y direction, so excessive vibration does not occur.

Next, the design method for the Z assist motor $4_{ZA}$ will be explained referring to Fig. 17. As shown in Fig. 17, $D_Z$ represents the distance in the Z direction between line L1 passing through the gravity center G of the levitated part and line L2 passing through the thrust action point of the X motor $4_X$ and $D_X$ represents the distance in the X direction between thrust action points of the Z assist motors $4_{ZA}$. Also, Kx represents the thrust constant of the X motor $4_X$ and $K_{ZA}$ represents the thrust constant of the Z assist motor $4_{ZA}$. Here, where $I_X$ represents the coil current flowing in the X coil 5x, moment M around the Y axis of the X thrust force $F_X$ of the X motor $4_X$ with the gravity center G as the center is expressed as follows:

$$M = 2 \times D_Z \times K_X \times I_X \ \ldots \ \text{(Equation 1)}$$

Moment M' around the Y axis of the Z assist motor $4_{ZA}$ with the gravity center G as the center is expressed as follows:

$$M' = 2 \times (1/2 \times D_X) \times K_{ZA} \times I_X \ \ldots \ \text{(Equation 2)}$$

When this is balanced with M, the moment around the Y axis is 100% compensated for by the Z assist motor $4_{ZA}$. Therefore, in accordance with (Equation 1) and (Equation 2), when the Z assist motor $4_{ZA}$ is designed so that thrust constant $K_Z$ satisfies the following equation:

$$K_Z = (2 \times D_Z/D_X) \times K_x \ \ldots \ \text{(Equation 3)}$$

it is possible to offset the rotation moment around the Y axis during acceleration/deceleration completely. For example, if $D_X$ is 200 mm and Dz is 20 mm, the optimum thrust constant $K_{ZA}$ of the Z assist motor $4_{ZA}$ is 1/5 of the thrust constant $K_X$ of the X motor $4_X$.

Particularly, since the X motor 4x and Z assist motor $4_{ZA}$ use the same coil, the thrust constant is simply proportional to the magnetic flux density produced by a yoke. Specifically, the magnetic flux density of the Z assist yoke $6_{ZA}$ should be N times as high as the magnetic flux density of the X yoke 6x. However, the following relation should hold:

$$N = 2 \times D_Z/D_X \quad ... \quad (Equation\ 4)$$

After the Z assist yoke $6_{ZA}$ of the Z assist motor $4_{ZA}$ is designed on the basis of this relation, the mass of the levitated part is determined and the distance between permanent magnets 11G for gravity compensation is decided and selection of magnets is made.

According to the magnetic levitation stage device in this embodiment as described above, higher speed and higher acceleration in positioning can be achieved without an increase in the Z motor size and magnetic field leakage can be suppressed.

Second Embodiment

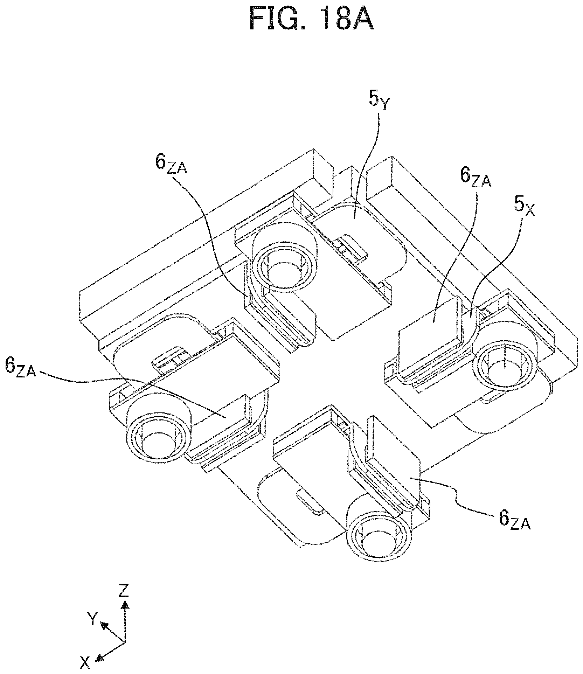

Next, a magnetic levitation stage device 100 according to the second embodiment of the present invention will be described using Fig. 18A to 18C. Repeated description of the same points as in the first embodiment is omitted.

Fig. 18A is a perspective view of the levitated part of the magnetic levitation stage device 100 as seen from below, in which the Z assist motor $4_{ZA}$ has a bended coil end. The figure corresponds to Fig. 8 for the first embodiment. As shown here, in this embodiment, one end of each of the X coil $5_X$ and the Y coil $5_Y$ is shaped by bending it 90 degrees in the -Z direction and a Z assist yoke $6_{ZA}$ is located in a manner to face it so that X thrust force $F_X$ or Y thrust force Fy can be generated and Z assist thrust force $F_{ZA}$ can be generated as in the first embodiment.

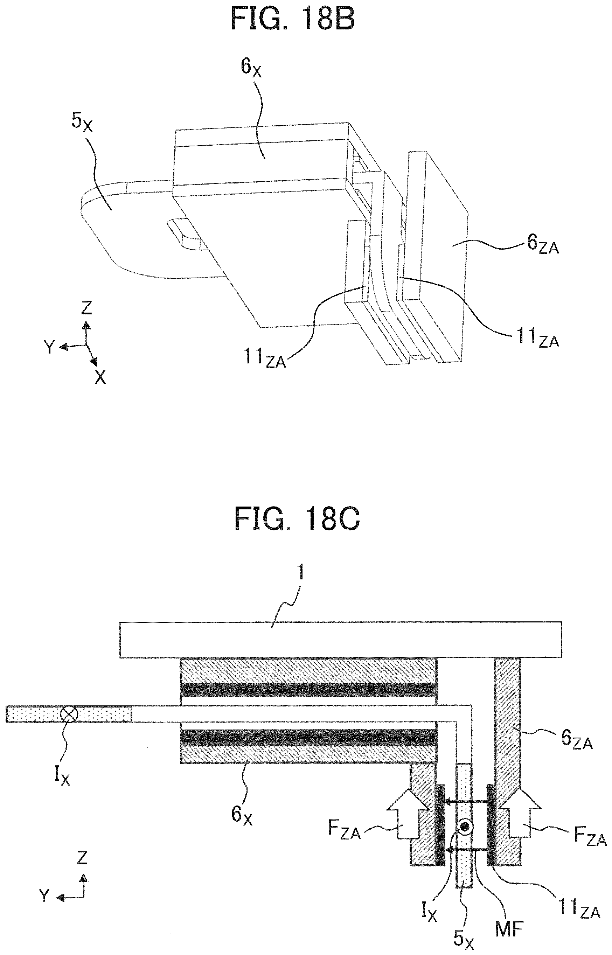

Fig. 18B shows one motor taken from Fig. 18A. Fig. 18C is a sectional view of the motor, taken along the YZ plane. As shown in these figures, the permanent magnet $11_{ZA}$ fixed on the Z assist yoke $6_{ZA}$ generates a magnetic flux MF and the coil current $I_X$ flowing in the X motor 4x generates a Z assist thrust force $F_{ZA}$.

In the magnetic levitation stage device according to this embodiment, the costs of the coil conductor wire winding process and resin molding process are higher but a larger Z assist thrust force $F_{ZA}$ can be generated than in the first embodiment.

Third Embodiment

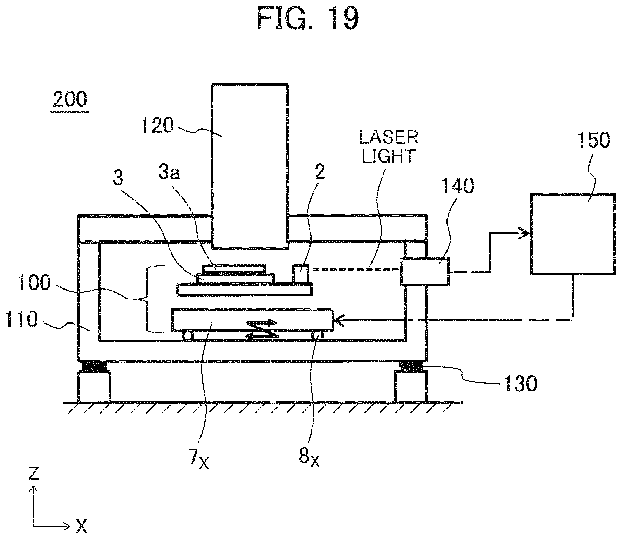

Lastly, a charged particle beam device or vacuum device according to this embodiment that is equipped with the magnetic levitation stage device according to the first or second embodiment will be described referring to Fig. 19. Repeated description of the same points as in the above embodiments is omitted.

The charged particle beam device according to this embodiment is a semiconductor measuring device 200 that includes a magnetic levitation stage device 100 for positioning an object and a vacuum chamber 110 for housing the magnetic levitation stage device 100. It is, for example, a length measuring SEM as a device to which a scanning electron microscope (SEM) is applied. The vacuum device according to this embodiment is the vacuum chamber 110 that houses the magnetic levitation stage device 100.

As shown in Fig. 19, the semiconductor measuring device 200 according to this embodiment includes: a magnetic levitation stage device 100; a vacuum chamber 110 for housing it; an electron optical lens barrel 120 fitted to the upper portion of the vacuum chamber 110; damping mounts 130 for supporting the vacuum chamber 110; a laser interferometer 140 fitted to a side face of the vacuum chamber 110 in a manner to face a bar mirror 2; and a controller 150 for controlling the magnetic levitation stage device 100 according to output of the laser interferometer 140. The inside of the vacuum chamber 110 is depressurized by a vacuum pump (not shown) and in a state of vacuum lower than the atmospheric pressure.

In the semiconductor measuring device 200 thus structured, the magnetic levitation stage device 100 positions an object placed on it, such as a semiconductor wafer 3a, the object is irradiated with an electron beam from the electron optical lens barrel 120 to take an image of a pattern on the object, and the line width of the pattern is measured and the shape accuracy is evaluated. For the magnetic levitation stage device 100, the position of the bar mirror 2 is measured by the laser interferometer 140 and positioning of the object held on the sample stage 3 of the magnetic levitation stage device 100, such as the semiconductor wafer 3a, is controlled by the controller 150.

Since the semiconductor measuring device 200 includes the magnetic levitation stage device 100 according to the first or second embodiment, higher speed and higher acceleration in positioning of the object such as the semiconductor wafer 3a can be achieved and magnetic field leakage can be suppressed. Therefore, neither distortion of the electron beam due to a leaked magnetic field nor deterioration in irradiation accuracy occurs, so the measuring accuracy of the semiconductor measuring device 200 can be improved. In addition, since the magnetic levitation stage device 100 adopts the magnetic levitation method for the levitation mechanism, it can be easily applied to the semiconductor measuring device 200 as a vacuum device and an excellent advantageous effect such as suppression of heat generation can be produced. The charged particle beam device and vacuum device in the present disclosure are not limited to semiconductor measuring devices.

Embodiments of the present invention have been so far described in detail using the drawings, but the concrete structures are not limited to these embodiments. Even design changes and the like that do not depart from the gist of the present invention are included in the present invention.

List of Reference Signs

| | |
|---|---|
| 1... | top table, |
| 2... | bar mirror, |
| 3... | sample stage, |
| 3a... | semiconductor wafer, |
| 4... | voice coil motor, |
| $4_X$... | X motor, |
| $4_Y$... | Y motor, |
| $4_Z$... | Z motor, |
| $4_{ZA}$... | Z assist motor, |
| 5... | coil, |
| $5_X$... | X coil, |
| $5_Y$... | Y coil, |
| $5_Z$... | Z coil, |
| 6... | yoke, |
| 6x... | X yoke, |
| $6_Y$... | Y yoke, |
| 6z... | Z yoke, |
| $6_{ZA}$... | Z assist yoke, |
| $7_X$... | X table |
| $7_Y$... | Y table, |
| 8, $8_X$, $8_Y$... | guide, |
| 9... | base, |
| 10, $10_Z$... | sensor, |
| $11_G$... | permanent magnet for gravity compensation, |
| $11_X$... | X yoke permanent magnet, |
| $11_{ZA}$... | Z assist yoke permanent magnet, |
| 100... | magnetic levitation stage device, |
| 110... | vacuum chamber, |
| 120... | electron optical lens barrel, |
| 130... | damping mount, |
| 140... | laser interferometer, |
| 150... | controller, |
| 200... | semiconductor measuring device |

**Claims**

1. A magnetic levitation stage device comprising:

a levitated part having a sample stage on which a sample is placed;
a non-levitated part located under the levitated part;
a horizontal thrust motor that has a horizontal thrust yoke located on a lower portion of the levitated part and a horizonal thrust coil located on an upper portion of the non-levitated part, and gives a horizontal thrust force to the levitated part when coil current is applied to the horizontal thrust coil; and
a vertical thrust motor that has a vertical thrust yoke located on the lower portion of the levitated part and a vertical thrust coil located on the upper portion of the non-levitated part, and gives a vertical thrust force to the levitated part when coil current is applied to the vertical thrust coil, wherein

on the lower portion of the levitated part, a vertical thrust assist yoke is located in a position to face an end of the horizontal thrust coil protruding from the horizontal thrust yoke, and

when coil current is applied to the horizontal thrust coil, the horizontal thrust yoke generates the horizontal thrust force and at the same time the vertical thrust assist yoke also generates a vertical assist thrust force.

2.   The magnetic levitation stage device according to Claim 1, wherein

the horizontal thrust coil is a rectangular coil with winding roughly in the shape of rectangle,
the vertical thrust assist yoke is located on the lower portion of the levitated part in a manner to face an end of the horizontal thrust coil in a long side direction.

3.   The magnetic levitation stage device according to Claim 2, wherein
the vertical thrust assist yoke has a vertical thrust assist magnet that generates a magnetic flux going across the end of the horizontal thrust coil from an inner circumference side to an outer circumference side or from the outer circumference side to the inner circumference side.

4.   The magnetic levitation stage device according to Claim 3, wherein on the non-levitated part, a gravity compensation magnet to make gravity compensation is located under the end of the horizontal thrust coil and in a position to face the vertical thrust assist magnet.

5.   The magnetic levitation stage device according to Claim 3, wherein

when two axes that intersect roughly at a center in a projection plane of the levitated part are defined as an X axis and a Y axis,
the horizontal thrust motor is a pair of X motors for generating an X thrust force in an X direction and a pair of Y motors for generating a Y thrust force in a Y direction, and
a horizontal thrust yoke of one Y motor is located in a first quadrant of an XY plane, a horizontal thrust yoke of one X motor is located in a second quadrant, a horizontal thrust yoke of the other Y motor is located in a third quadrant, and a horizontal thrust yoke of the other X motor is located in a fourth quadrant.

6.   The magnetic levitation stage device according to Claim 5, wherein a vertical thrust assist yoke is located on the X axis facing the end of the horizontal thrust coil of the X motor in the long side direction and a vertical thrust assist yoke is located on the Y axis facing the end of the horizontal thrust coil of the Y motor in the long side direction.

7.   The magnetic levitation stage device according to Claim 1, wherein

the horizontal thrust coil is shaped by bending 90 degrees an end of a rectangular coil with winding roughly in the shape of rectangle, and
the vertical thrust assist yoke is located under the levitated part in a manner to face both faces of the bended end of the horizontal thrust coil.

8.   A charged particle beam device comprising:

the magnetic levitation stage device according to any one of Claim 1 to Claim 7; and
an electron optical lens barrel located above the sample stage of the magnetic levitation stage device.

9.   A vacuum device comprising:

the magnetic levitation stage device according to any one of Claim 1 to Claim 7;
a vacuum chamber that houses the magnetic levitation stage device; and
a vacuum pump that depressurizes the vacuum chamber.

10.  An assist thrust force generating method for a magnetic levitation stage device that comprises:

a levitated part having a sample stage on which a sample is placed; a non-levitated part located under the levitated part; a horizontal thrust motor that has a horizontal thrust yoke located on a lower portion of the levitated part and a horizonal thrust coil located on an upper portion of the non-levitated part and gives a horizontal thrust force to the levitated part when coil current is applied to the horizontal thrust coil; a vertical thrust motor that has a vertical thrust yoke located on the lower portion of the levitated part and a vertical thrust coil located on the upper portion of the non-levitated part and gives a vertical thrust force to the levitated part when coil current is applied to the vertical thrust coil; and a vertical thrust assist yoke located on the lower portion of the levitated part and in a position to face an end of the horizontal thrust coil protruding from the horizontal thrust yoke, wherein when coil current is applied to the horizontal thrust coil, the horizontal thrust yoke generates the horizontal thrust force and at the same time the vertical thrust assist yoke generates a vertical assist thrust force.

# FIG. 1

# FIG. 2

# FIG. 3

# FIG. 4

# FIG. 5

# FIG. 6

# FIG. 7

# FIG. 8

# FIG. 9

# FIG. 10

# FIG. 11A

# FIG. 11B

# FIG. 12

# FIG. 13

# FIG. 14

# FIG. 15

# FIG. 16

# FIG. 17

# FIG. 18A

# FIG. 18B

# FIG. 18C

# FIG. 19

## INTERNATIONAL SEARCH REPORT

| International application No. |
| --- |
| PCT/JP2020/011412 |

**A. CLASSIFICATION OF SUBJECT MATTER**
Int.Cl.  H02K33/18(2006.01)i, H02N15/00(2006.01)i, H01L21/68(2006.01)i
FI:  H01L21/68K, H02K33/18A, H02N15/00

According to International Patent Classification (IPC) or to both national classification and IPC

**B. FIELDS SEARCHED**

Minimum documentation searched (classification system followed by classification symbols)
Int.Cl.  H02K33/18, H02N15/00, H01L21/68

Documentation searched other than minimum documentation to the extent that such documents are included in the fields searched
Published examined utility model applications of Japan    1922-1996
Published unexamined utility model applications of Japan    1971-2020
Registered utility model specifications of Japan    1996-2020
Published registered utility model applications of Japan    1994-2020

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2017-184600 A (RICOH IMAGING CO., LTD.) 05.10.2017 (2017-10-05), paragraphs [0026]-[0044], fig. 2-6 | 1-10 |
| A | JP 2011-3873 A (NIKON CORPORATION) 06.01.2011 (2011-01-06), paragraphs [0065]-[0083], fig. 6-11 | 1-10 |

☐ Further documents are listed in the continuation of Box C.    ☒ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 18.05.2020 | 02.06.2020 |

| Name and mailing address of the ISA/ | Authorized officer |
| --- | --- |
| Japan Patent Office 3-4-3, Kasumigaseki, Chiyoda-ku, Tokyo 100-8915, Japan | Telephone No. |

Form PCT/ISA/210 (second sheet) (January 2015)

**INTERNATIONAL SEARCH REPORT**
Information on patent family members

International application No.

PCT/JP2020/011412

```
JP 2017-184600 A   05.10.2017   US 2017/0285361 A1
                                paragraphs [0052]-[0067], fig. 2-6

JP 2011-3873 A     06.01.2011   US 2010/0157274 A1
                                paragraphs [0093]-[0110], fig. 6-11
                                KR 10-2011-0110197 A
```

Form PCT/ISA/210 (patent family annex) (January 2015)

**EP 4 007 136 A1**

REFERENCES CITED IN THE DESCRIPTION

**Patent documents cited in the description**

- US 20020137358
- JP H111999069762 A